# EUROPEAN PATENT APPLICATION

(11) **EP 2 166 578 A2**
(43) Date of publication of application: **24.03.2010**
(21) Application number: 09004623.6
(22) Date of filing: 31.03.2009
(51) Int. Cl.: H01L 31/078, H01L 31/075

(54) **Photovoltaic device and method of manufacturing the same**

(30) Priority: 22.09.2008 KR 20080092879; 23.09.2008 KR 20080093145
(71) Applicant: Samsung Electronics Co., Ltd., Yeongtong-gu Suwon-city, Gyeonggi-do 442-742 (KR)
(72) Inventor: Lee, Czang-Ho, Hwaesong-si Gyeonggi-do (KR); Lee, Byoung-Kyu, Suwon-sie Gyeonggi-do (KR); Lim, Mi-Hwa, Seocheon-gun Chungcheongnam-do (KR); Seo, Joon-Young, Seoul (KR); Shin, Myung-Hun, Suwon-sie, Gyeonggi-do (KR); Oh, Min-Seok, Yonging-si, Gyeonggi-do (KR); Kang, Ku-Hyun, Suwon-si, Gyeonggi-do (KR); Nam, Yuk-Hyun, Goyang-si Gyeonggi-do (KR); Jung, Seung-Jae, Seoul (KR); Park, Min, Seoul (KR)
(74) Representative: Schmidt, Sven Hendrik

(57) **Abstract**

In one or more embodiments of a photovoltaic device and a method of manufacturing the photovoltaic device, a first conductive layer, a first light-absorbing layer and a second conductive layer may be formed on a substrate, in sequence. A temperature for forming the second conductive layer may be lower than a temperature for forming the first conductive layer and a temperature for forming the first light-absorbing layer.

## Description

### BACKGROUND

### 1. Technical Field

Example embodiments of this disclosure relate to a photovoltaic device and a method of manufacturing the photovoltaic device.

### 2. Related Art

A solar cell is an element for electric power generation using solar energy. A conventional solar cell includes a p-n junction diode, and is classified into a plurality of solar cells based on a material of a light-absorbing layer.

A solar cell using silicon as the light-absorbing layer is classified as either a crystalline wafer type solar cell or a thin film type solar cell. The crystalline wafer type solar cell includes monocrystalline silicon, polycrystalline silicon, etc. The thin film type solar cell includes amorphous silicon, polycrystalline silicon, etc. A solar cell using a compound as the light-absorbing layer includes CuInGaSe2 (CIGS), CdTe, etc., and is classified as a compound thin film solar cell, a Group III-V solar cell, a dye-sensitized solar cell (DSSC), an organic solar cell, etc.

The thin film type solar cell includes a thin film formed on a transparent substrate such as a glass substrate, a plastic substrate, etc., or a metal substrate such as stainless foil. A diffusion length of carriers in the thin film is shorter than a diffusion length of the carriers in the crystalline layer, so that the efficiency of absorbing electron-hole pairs generated by the light is low in the p-n junction structure. In order to increase the efficiency of absorbing the electron-hole pairs, a light-absorbing layer including intrinsic (i) semiconductor is interposed between a p-semiconductor layer and an n-semiconductor layer to form a PIN structure.

In the PIN structure, the i-semiconductor layer of the PIN structure is depleted by the p-semiconductor layer and the n-semiconductor layer having greater concentration than the i-semiconductor layer to form an electric field in the i-semiconductor layer. The electron-hole pairs generated in the i-semiconductor layer by the light are drifted toward the n-semiconductor layer and the p-semiconductor layer to generate a current.

The thin film type solar cell is classified into a superstrate type solar cell and a substrate type solar cell. The superstrate type solar cell includes a transparent conductive layer (TCO), the PIN structure and an electrode formed on a transparent substrate. The substrate type solar cell includes an NIP structure, a transparent conductive layer and a grid structure formed on a metal substrate. In the superstrate type solar cell and the substrate type solar cell, the light is incident into the light-absorbing layer of the i-semiconductor layer through the transparent conductive layer and the p-semiconductor layer. However, the drift mobility of the electron-hole pairs generated in the superstrate type solar cell due to the light is different from the drift mobility of the electron-hole pairs generated in the substrate type solar cell due to the light.

The efficiency of the solar cell is changed by a cell structure, the thickness of the thin films in the solar cell, etc. In particular, the cell structure is important in improving the efficiency of the solar cell.

The thin film type solar cell including the amorphous silicon (a-Si:H), microcrystalline silicon (mc-Si:H) or amorphous silicon-germanium (a-SiGe:H) has the light-absorbing layer of no more than about several microns. Also, a light-absorbing coefficient of the silicon is low. Thus, the efficiency of light absorption using the PIN junction structure is low. Therefore, the amorphous silicon (a-Si:H) and the microcrystalline silicon (mc-Si:H) of the PIN structure is stacked in a double-layer structure of a triple-layer structure to increase the efficiency of the solar cell. When the PIN structure is stacked, unit solar cells are electrically connected to each other in series to increase the voltage level generated by the solar cell and power generation efficiency.

However, a diffusion speed of dopants in the doped p-semiconductor layer that is implanted by p-type impurities at a high concentration is fast, so that the efficiency of light absorption at an interface between the p-semiconductor layer and the i-semiconductor layer is decreased by recombination at the interface. In order to decrease the recombination, the solar cell is deposited at a low temperature of no more than about 200°C. When the solar cell is deposited at the low temperature, however, the quality of the light-absorbing layer deteriorates, decreasing the solar cell's optical characteristics and the reliability.

When the amorphous silicon thin film that is deposited at the low temperature is exposed through the light, hydrogen concentration in the amorphous silicon thin film is increased to be about 15 at% to about 20 at%, so that the density of dangling bonds is increased. Thus, an electric field in the amorphous silicon thin film may be decreased by the Staebler-Wronski effect, thereby decreasing the efficiency of light absorption.

### SUMMARY

Example embodiments of the present disclosure provide a photovoltaic device of a substrate type solar cell, which may be capable of changing the deposition temperature of a light-absorbing layer to control hydrogen concentration and bandgap energy, thereby improving the efficiency and reliability of the solar cell. Example embodiments of the present disclosure also provide a method of manufacturing the photovoltaic device.

In an embodiment, a method of manufacturing a photovoltaic device may include forming a first conductive layer, a first light-absorbing layer, and a second conductive layer on a substrate, in sequence. A temperature for forming the second conductive layer may be lower than a temperature for forming the first conductive layer and a temperature for forming the first light-absorbing layer.

The temperature for forming the first conductive layer and temperature for forming the first light-absorbing layer may be a temperature of about 300°C to about 400°C. The temperature for forming the second conductive layer may be about 150°C to about 200°C.

In accordance with another embodiment, there is provided a method of manufacturing a photovoltaic device. A first cell may be formed on a substrate. The first cell may include a first conductive layer, a first light-absorbing layer, and a second conductive layer. A temperature for forming the second conductive layer may be lower than a temperature for forming the first conductive layer and a temperature for forming the first light-absorbing layer. A second cell may be formed on the first cell. The second cell may include a third conductive layer, a second light-absorbing layer, and a fourth conductive layer. A temperature for forming the third conductive layer may be no higher than a temperature for forming the second conductive layer. A temperature for forming the second light-absorbing layer may be no higher than the temperature for forming the second conductive layer. A temperature for forming the fourth conductive layer may be no higher than the temperature for forming the second light-absorbing layer.

The first light-absorbing layer of the first cell may be formed at the temperature of about 300°C to about 400°C. The second light-absorbing layer of the second cell may be formed at the temperature of about 150°C to about 200°C.

In one or more embodiments, the method of manufacturing the photovoltaic device may further include forming a third cell between the first and second cells, the third cell including an amorphous or monocrystalline silicon-germanium semiconductor layer. The third cell may be formed at the temperature of about 200°C to about 300°C.

In accordance with another embodiment, there is provided a photovoltaic device including a first conductive layer, a first light-absorbing layer, and a second conductive layer. The first conductive layer may be formed on a substrate. The first light-absorbing layer may be formed on the substrate. The second conductive layer may be formed on the substrate. A hydrogen concentration of the second conductive layer may be greater than a hydrogen concentration of the first conductive layer and a hydrogen concentration of the first light-absorbing layer.

The hydrogen concentration of the first conductive layer may be greater than the hydrogen concentration of the first light-absorbing layer and the hydrogen concentration of the second conductive layer, and the hydrogen concentration of the second conductive layer may be smaller than the hydrogen concentration of the first conductive layer and the hydrogen concentration of the first light-absorbing layer. Also, the hydrogen concentration of the first light-absorbing layer may be less than the hydrogen concentration of the first conductive layer and may be greater than the hydrogen concentration of the second conductive layer. The first conductive layer may include an n-semiconductor, and the second conductive layer may include a p-semiconductor.

A bandgap energy of the second conductive layer may be greater than a bandgap energy of the first conductive layer. The bandgap energy of the first conductive layer may be less than a bandgap energy of the first light-absorbing layer, and the bandgap energy of the first light-absorbing layer may be less than the bandgap energy of the second conductive layer.

In accordance with a further embodiment, the photovoltaic device may include a first cell and a second cell. The first cell may include a first conductive layer, a first light-absorbing layer, and a second conductive layer on a substrate. The second cell may include a third conductive layer, a second light-absorbing layer, and a fourth conductive layer on the first cell. The second light-absorbing layer may have a smaller thickness than the first light-absorbing layer. A hydrogen concentration of the first light-absorbing layer may be less than a hydrogen concentration of the second light-absorbing layer.

The first and second conductive layers may include an n-semiconductor, and the third and fourth conductive layers may include a p-semiconductor.

The hydrogen concentration of the first light-absorbing layer may be about 0.1 at% to about 10 at%. The hydrogen concentration of the second light-absorbing layer may be about 15 at% to about 20 at%.

The bandgap energy of the first light-absorbing layer may be about 1.1 eV to about 1.75 eV. The bandgap energy of the second light-absorbing layer may be about 1.8 eV to about 2.0 eV.

A difference between the bandgap energies of the first and second light-absorbing layers may be about 0.05 eV to about 0.9 eV.

The second light-absorbing layer may be more adjacent to a light incident surface of the photovoltaic device than the first light-absorbing layer. The first light-absorbing layer may include microcrystalline silicon. The photovoltaic device may further include a third cell between the first and second cells, the third cell including amorphous or monocrystalline silicon-germanium. Alternatively, the photovoltaic device may further include a third cell between the first and second cells. The third cell may include a third light-absorbing layer, and a bandgap energy of the third light-absorbing layer may be about 1.4 eV to about 1.6 eV.

In one or more embodiments, the deposition temperature of a light-absorbing layer may be increased to decrease hydrogen concentration, thereby preventing deterioration of a photovoltaic device, which may be caused by long exposure to sunlight. Also, a p-semiconductor layer may be formed at a low temperature, so that diffusion of p-type impurities may be decreased. Thus, recombination of electron-hole pairs may be decreased, thereby improving optical characteristics.

### BRIEF DESCRIPTION OF THE DRAWINGS

The above embodiments and other features and advantages of the present disclosure will become more apparent by describing detailed example embodiments thereof with reference to the accompanying drawings.

FIGS. 1 to 5 are cross-sectional views illustrating a method of manufacturing a photovoltaic device for a solar cell in accordance with one embodiment;

FIG 6 is a cross-sectional view illustrating a photovoltaic device for a solar cell in accordance with another embodiment;

FIG. 7 is a graph illustrating a relationship between the thickness of a light-absorbing layer and a short-circuit current in accordance with an embodiment; and

FIG 8 is a cross-sectional view illustrating a photovoltaic device for a solar cell in accordance with still another embodiment.

### DETAILED DESCRIPTION

One or more embodiments are described more fully hereinafter with reference to the accompanying drawings, in which example embodiments are shown. The present invention may, however, be embodied in many different forms and should not be construed as limited to the example embodiments set forth herein. Rather, these example embodiments are provided so that this disclosure will be thorough and complete, and will fully convey the scope of the embodiments to those skilled in the art. In the drawings, the sizes and relative sizes of layers and regions may be exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular example embodiments only and is not intended to be limiting of the present invention. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

Example embodiments of the invention are described herein with reference to cross-sectional illustrations that are schematic illustrations of idealized example embodiments (and intermediate structures) of the present invention. As such, variations from the shapes of the illustrations as a result, for example, of manufacturing techniques and/or tolerances, are to be expected. Thus, example embodiments of the present invention should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of the present invention.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, one or more embodiments will be explained in detail with reference to the accompanying drawings.

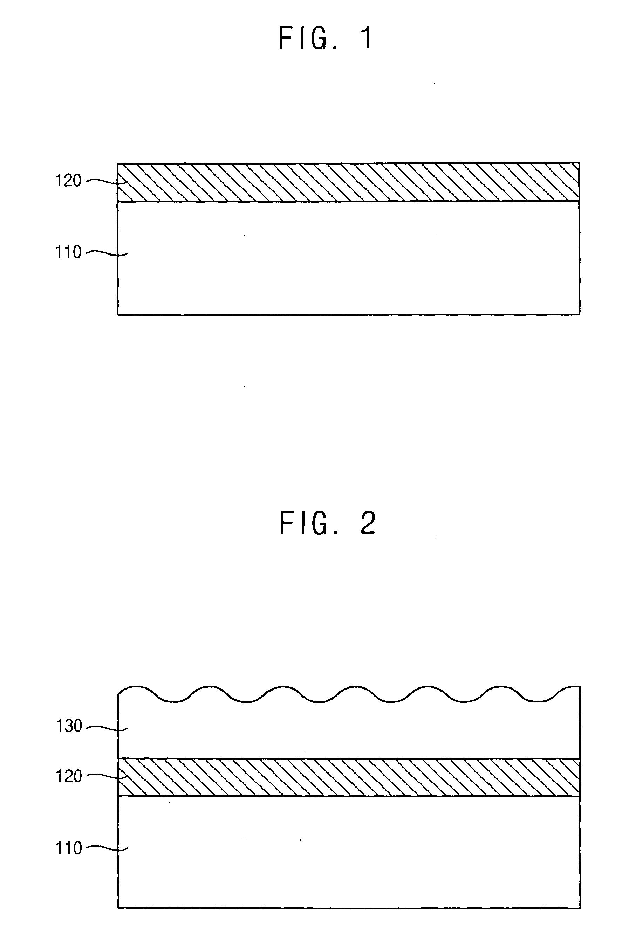

FIGS. 1 to 5 are cross-sectional views illustrating a method of manufacturing a photovoltaic device for a solar cell in accordance with one embodiment. FIG. 1 is a cross-sectional view illustrating forming a reflecting layer 120 on a substrate 110 in accordance with one embodiment of the present invention.

Referring to FIG 1, the reflecting layer 120 may be formed on the substrate 110. The substrate 110 may include a hard material or a flexible material. Examples of the hard material that may be used for the substrate 110 include glass, quartz, silicon, synthetic resin, metal, etc. Examples of the flexible material that may be used for the substrate 110 include metal, synthetic resin, etc. When the flexible material includes the metal, the substrate 110 may include a stainless steel sheet, an aluminum foil, etc. Examples of a reflective material that may be used for the reflecting layer 120 includes silver, aluminum, etc.

FIG 2 is a cross-sectional view illustrating forming a rear electrode 130 on the reflecting layer 120 shown in FIG 1 in accordance with an embodiment.

Referring to FIG 2, the rear electrode 130 may be formed on the reflecting layer 120. For example, the rear electrode 130 may be formed through a physical vapor deposition (PVD) method. Examples of a transparent conductive material that may be used for the rear electrode 120 include ZnO:Al, ZnO:B, SnO2, indium tin oxide (ITO), etc. A texture having a predetermined height and a predetermined size may be formed on the rear electrode 130 to increase the efficiency of absorbing incident light. For example, the texture may have an embossing pattern, recesses and protrusions, protrusions, recesses, grooves, prism patterns, etc.

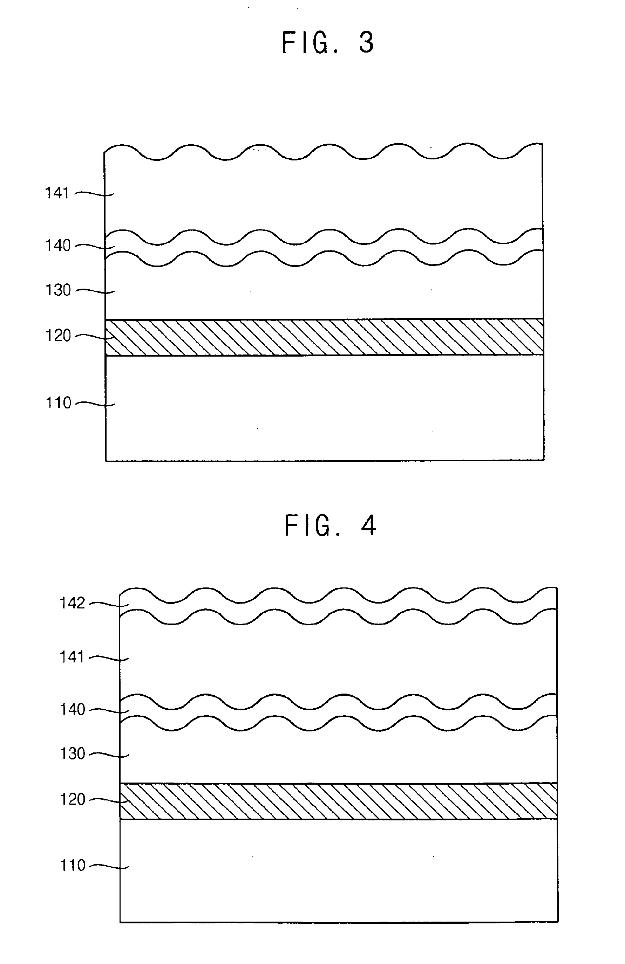

FIG 3 is a cross-sectional view illustrating forming a first conductive layer 140 and a first light-absorbing layer 141 on the rear electrode 130 shown in FIG 2 in accordance with an embodiment.

Referring to FIG 3, the first conductive layer 140 and the first light-absorbing layer 141may be deposited on the rear electrode 130 through a chemical vapor deposition (CVD) method, in sequence. The first conductive layer 140 and the first light-absorbing layer 141 may be deposited at a temperature of about 300°C to about 400°C.

FIG. 4 is a cross-sectional view illustrating forming a second conductive layer 142 on the first light-absorbing layer 141 shown in FIG. 3 in accordance with an embodiment.

Referring to FIG. 4, the second conductive layer 142 may be formed on the first light-absorbing layer 141 at a temperature of about 150°C to about 200°C. The second conductive layer 142 may include different impurities from the first conductive layer 140. The hydrogen concentration of the light-absorbing layer 141 including amorphous silicon at the temperature of about 150°C to about 200°C may be about 5 at% to about 10 at%. The hydrogen concentration of the light-absorbing layer 141 including microcrystalline silicon at the temperature of about 150°C to about 200°C may be about 0.1 at% to about 2 at%. In FIG. 4, the first conductive layer 140 may include n-type impurities, and the second conductive layer 142 may include p-type impurities. Alternatively, the first conductive layer 140 may include p-type impurities, and the second conductive layer 142 may include n-type impurities.

In another embodiment, the first conductive layer 140, the first light-absorbing layer 141, and the second conductive layer 142 may be formed at a temperature of about 150°C to about 200°C, in sequence. When the first conductive layer 140, the first light-absorbing layer 141, and the second conductive layer 142 are formed at a temperature of about 150°C to about 200°C, in sequence, the hydrogen concentration in the light-absorbing layer may be about 15 at% to about 20 at%, so that dangling bonds may be increased in the light-absorbing layer. Thus, the efficiency of the solar cell including the light-absorbing layer may be gradually decreased by about 15% to about 20% by the Staebler-Wronski effect. However, when the light-absorbing layer is formed at the high temperature, the hydrogen concentration may be decreased, thereby preventing the Staebler-Wronski effect.

However, in a superstrate type solar cell, light may be incident into the solar cell from a rear surface of a substrate of the solar cell, and a p-type conductive layer, a light-absorbing layer, and an n-type conductive layer may be formed on a front surface of the substrate. Thus, when the conductive layer and the light-absorbing layer are deposited at a high concentration, p-type impurities such as boron having high diffusibility may be diffused toward the light-absorbing layer, so that recombination at a boundary between the p-type conductive layer and the light-absorbing layer is increased, thereby decreasing the efficiency of the solar cell. Generation may represent generation of electron-hole pairs in a semiconductor or excitation of electrons from a valence band to a conduction band. Recombination may represent annihilation of an electron-hole pair by transferring an electron from the conductive band to the valence band.

In an embodiment, the solar cell may be the substrate type, so that the n-type conductive layer and the light-absorbing layer may be formed on the front surface of the substrate at the high temperature of about 300°C to about 400°C, so that the hydrogen concentration is decreased by about 5 at% to about 10 at% in the amorphous silicon or by about 0.1 at% to about 2 at% in the microcrystalline silicon. The p-type conductive layer may be formed on the light-absorbing layer at the temperature of about 150°C to about 200°C, so that the diffusion speed of the n-type impurities is slow. Thus, the recombination at the boundary between the n-type conductive layer and the light-absorbing layer may be decreased, although the n-type conductive layer and the light-absorbing layer are deposited at the high temperature. Thus, the efficiency of the solar cell may be improved.

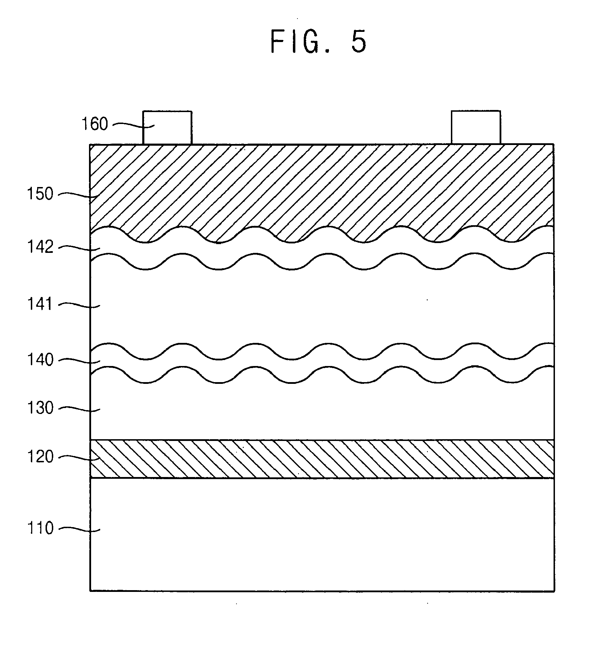

FIG. 5 is a cross-sectional view illustrating forming an anti-reflective layer 150 and an entire electrode 160 on the second conductive layer 142 shown in FIG. 4 in accordance with an embodiment.

Referring to FIG. 5, the anti-reflective layer 150 and the entire electrode 160 may be formed on the second conductive layer 142. The anti-reflective layer 150 may prevent reflection on a surface of the solar cell to decrease loss of the light. The anti-reflective layer 150 may include a multilayer or monolayer structure having an oxide layer, a nitride layer, an insulating layer, a transparent conductive layer, etc. The anti-reflective layer 150 may further include an anti-reflective (AR) coating including anti-reflective material such as MgF2. A conductive material such as metal may be deposited on the anti-reflective layer 150 and may be patterned to form the entire electrode 160.

Hereinafter, a photovoltaic device in accordance with another embodiment will be explained. An embodiment of a photovoltaic device may be substantially the same as the photovoltaic device of FIGS. 1 to 5 except physical-chemical characteristics of a first conductive layer, a first light-absorbing layer, and a second conductive layer.

The photovoltaic device may include the first conductive layer, the first light-absorbing layer, and the second conductive layer formed on the substrate. The hydrogen concentration of the second conductive layer may be no less than that of the first light-absorbing layer and the second conductive layer. The first conductive layer may include an n+ semiconductor layer, and the second conductive layer may include a p+ semiconductor layer.

For example, the first light-absorbing layer may include an i-semiconductor layer.

The n+ semiconductor layer may be deposited at a temperature of about 250°C to about 350°C. The bandgap energy of the n+ semiconductor layer may be about 1.6 eV to about 1.7 eV, and the hydrogen concentration of the n+ semiconductor layer may be about 5 at% to about 10 at%. The n+ semiconductor layer may be electrically conductive.

The i-semiconductor layer may be deposited at a temperature of about 150°C to about 250°C. The bandgap energy of the i-semiconductor layer may be about 1.7 eV to about 1.9 eV, and the hydrogen concentration of the i-semiconductor layer may be about 10 at% to about 20 at%. The i-semiconductor layer may be highly light-absorbing layer.

The p+ semiconductor layer may be deposited at a temperature of about 100°C to about 150°C. The bandgap energy of the p+ semiconductor layer may be about 2.0 eV to about 2.2 eV, and the hydrogen concentration of the p+ semiconductor layer may be no less than about 20 at%.

The hydrogen concentration of the first conductive layer may be greater than those of the first light-absorbing layer and the second conductive layer. The hydrogen concentration of the second conductive layer may be less than those of the first conductive layer and the first light-absorbing layer. The hydrogen concentration of the first light-absorbing layer may be between those of the first light-absorbing layer and the second conductive layer.

The bandgap energy of the second conductive layer may be greater than that of the first conductive layer. The bandgap energy of the second conductive layer may be greater than those of the first light-absorbing layer and the first conductive layer. The bandgap energy of the first conductive layer may be less than those of the second conductive layer and the first light-absorbing layer. The bandgap energy of the first light-absorbing layer may be between those of the first conductive layer and the second conductive layer.

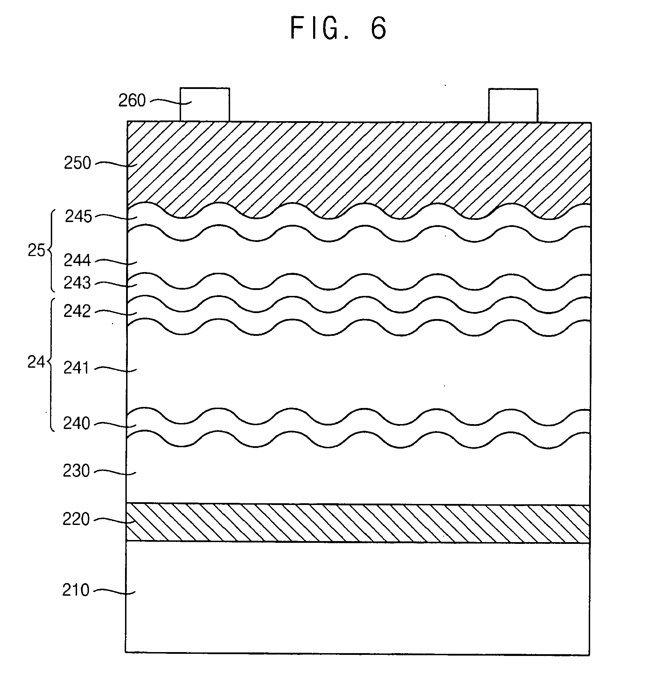

FIG 6 is a cross-sectional view illustrating a photovoltaic device for a solar cell in accordance with another embodiment.

Referring to FIG 6, a first cell 24, a second cell and an anti-reflective layer 250 may be formed on a substrate 210. The first cell 24 may include a first conductive layer 240, a first light-absorbing layer 241, and a second conductive layer 242. The second cell 25 may include a third conductive layer 243, a second light-absorbing layer 244 and a fourth conductive layer 245. The second cell 25 may be interposed between the first cell 24 and the anti-reflective layer 250.

A step for forming the first cell 24 on the substrate 210 may be substantially the same as shown in FIGS. 1 to 5. Thus, any further repetitive explanations concerning the above-mentioned elements will be omitted.

In order to form the second cell 25, the third conductive layer 243 and the second light-absorbing layer 244 may be formed on the second conductive layer 242 of the first cell 24. The third conductive layer 243 has opposite polarity to the second conductive layer 242, and may include substantially the same impurities as the first conductive layer 240 of the first cell 24. The third conductive layer 243 and the second light-absorbing layer 244 may be deposited at substantially the same temperature or at a lower temperature than the temperature for forming the second conductive layer 242. The fourth conductive layer 245 may then be formed. The fourth conductive layer 245 may have substantially the same polarity as the second conductive layer 242 of the first cell 24, and may have different impurities generating opposite polarity to the third conductive layer 243 of the second cell 25. The fourth conductive layer 245 may be formed at lower temperature than the temperature for forming the third conductive layer 243 and the second light-absorbing layer 244 of the second cell 25.

The first light-absorbing layer 241 of the first cell 24 may be formed at a temperature of about 300°C to about 400°C, and the second light-absorbing layer 244 of the second cell 25 may be formed at a temperature of about 150°C to about 200°C.

For example, the first conductive layer 240 and the third conductive layer 243 include the n-type impurities, and the second conductive layer 242 and the fourth conductive layer 245 may include the p-type impurities.

As described above, the second light-absorbing layer 244 of the second cell 25 may be formed at the temperature of about 150°C to about 200°C, so that the hydrogen concentration of the second light-absorbing layer 244 including amorphous silicon may be about 15 at% to about 20 at%. The first light-absorbing layer 241 of the first cell 24 may be formed at the temperature of about 300°C to about 400°C, so that the hydrogen concentration of the first light-absorbing layer 241 including the amorphous silicon may be about 5 at% to about 10 at%. When the first light-absorbing layer 241 includes microcrystalline silicon (mc-Si:H), the hydrogen concentration of the first light-absorbing layer 241 may be no more than about 2 at%.

Although the second conductive layer 242 of the first cell 24, which may include the p-type impurities, makes contact with the third conductive layer 243 of the second cell 25, which may include the n-type impurities, the third conductive layer 243 of the second cell 25 may be formed at the lower temperature than the second conductive layer 242 of the first cell 24, so that the p-type impurities may not diffuse toward the third conductive layer 243 including the n-type impurities. The fourth conductive layer 245 of the second cell 25, which may include the p-type impurities, may be formed at the lower temperature as the third conductive layer 243 and the second light-absorbing layer 244 of the second cell 25, so that the p-type impurities may not diffuse toward the second light-absorbing layer 244.

The first cell 24 may include the first light-absorbing layer 241 including the microcrystalline silicon (mc-SiH) and the second cell 25 may include the second light-absorbing layer 244 including amorphous silicon, so that the bandgaps of the first and second cells 24 and 25 may be different from each other. Thus, the first and second cells 24 and 25 absorb lights having different wavelengths, so that the efficiency of the solar cell may be improved.

The first light-absorbing layer 241 of the first cell 24, which may be deposited at the high temperature and may include the microcrystalline silicon (mc-Si:H), has the bandgap energy of about 1.1 eV to about 1.2 eV. The second light-absorbing layer 244 of the second cell 25, which may be deposited at the low temperature and may include the amorphous silicon, has the bandgap energy of about 1.8 eV to about 2.0 eV.

A third cell (not shown) may be interposed between the first and second cells 24 and 25. The third cell may include amorphous silicon-germanium, and may be formed at a temperature lower than the temperature for forming the first light-absorbing layer 241 of the first cell 24 and higher than the temperature for forming the second light-absorbing layer 244 of the second cell 25. The third cell may be formed at the temperature of about 200°C to about 300°C. The bandgap energy of the third cell may be about 1.4 eV to about 1.6 eV.

The photovoltaic device of the present embodiment may include a plurality of cells stacked with each other, and the cells include a plurality of light-absorbing layers having different hydrogen concentrations.

Referring to FIG. 6, a reflecting layer 220 may be formed on a substrate, and rear electrodes 130, 230, and 330 may be formed on the reflecting layer 220. Examples of a reflective material that may be used for the reflecting layer 220 include aluminum, silver, etc. The reflecting layer 220 reflects light towards the light-absorbing layers 241 and 244. The rear electrode 230 may include a transparent conductive material, so that the reflected light may be incident into the light-absorbing layers 241 and 244 through the rear electrode 230. Examples of the transparent conductive material that may be used for the rear electrode 230 include ZnO:Al, ZnO:B, SnO2, ITO, etc. A texture having a predetermined height and a predetermined size may be formed on a surface of the rear surface 230 to improve the efficiency of the light incident into the rear surface 230.

The first cell 24 and the second cell 25 may be stacked on the rear electrode 230, in sequence. The first cell 24 may include the first conductive layer 240, the first light-absorbing layer 241 and the second conductive layer 242. The second cell 25 may include the third conductive layer 243, the second light-absorbing layer 244 and the fourth conductive layer 245. The first light-absorbing layer 241 has lower hydrogen concentration than the second light-absorbing layer 244. When the first light-absorbing layer 241 includes the amorphous silicon, the hydrogen concentration of the first light-absorbing layer 241 may be about 5 at% to about 10 at%. When the first light-absorbing layer 241 includes the microcrystalline silicon, the hydrogen concentration of the first light-absorbing layer 241 may be about 0.1 at% to about 2 at%. The hydrogen concentration of the second light-absorbing layer 244 may be about 15 at% to about 20 at%.

The first conductive layer 240, the third conductive layer 243, the second conductive layer 242, and the fourth conductive layer 245 include substantially the same impurities. In FIG 6, each of the first and third conductive layers 240 and 243 include an n-type conductive layer including phosphorus. Each of the second and fourth conductive layers 242 and 245 include a p-type conductive layer including fluorine. Alternatively, each of the first and third conductive layers 240 and 243 include the p-type conductive layer including fluorine, and each of the second and fourth conductive layers 242 and 245 include the n-type conductive layer including phosphorus. Also, the bandgap energy of the first light-absorbing layer 241 may be about 1.1 eV to about 1.75 eV, and the bandgap energy of the second light-absorbing layer 244 may be about 1.8 eV to about 2.0 eV. The first and second light-absorbing layers 241 and 244 may include amorphous silicon or microcrystalline silicon.

The difference between the bandgap energies of the first and second light-absorbing layers 241 and 244 may be about 0.05 eV to about 0.4 eV. For example, the first light-absorbing layer 241 may have a smaller bandgap energy than the second light-absorbing layer 244, and the second light-absorbing layer 244 may be more adjacent to a light incident surface of the photovoltaic device than the first light-absorbing layer 241.

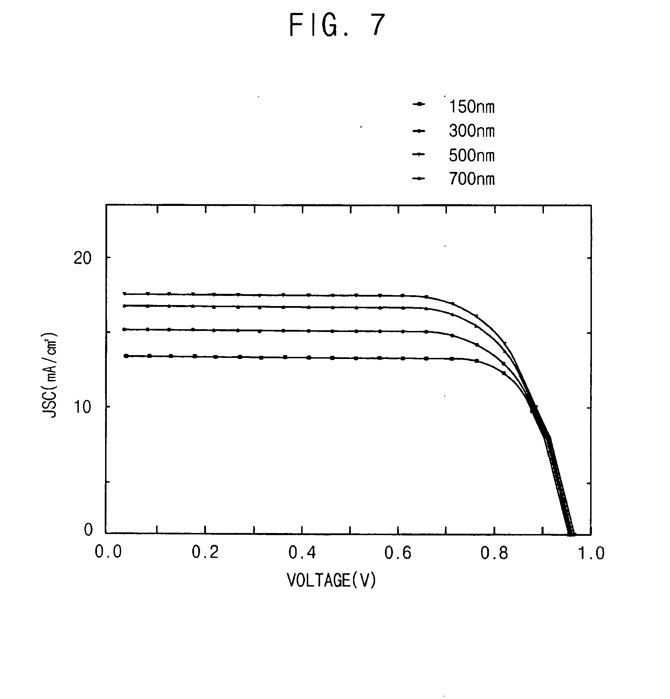

FIG. 7 is a graph illustrating a relationship between the thickness of a light-absorbing layer and a short-circuit current in accordance with an embodiment.

Referring to FIG. 7, the short-circuit current may be increased as the thickness of the light-absorbing layer is increased at a predetermined voltage. The light efficiency of the solar cell is a function of a summation of the short-circuit current, an open voltage (Voc), and a fill factor (FF). Thus, the light efficiency of the solar cell may be increased by increasing of the short-circuit current. When the light-absorbing layer is deposited at the high temperature, the deposition speed of the light-absorbing layer may be increased so that the light-absorbing layer of high thickness may be easily formed.

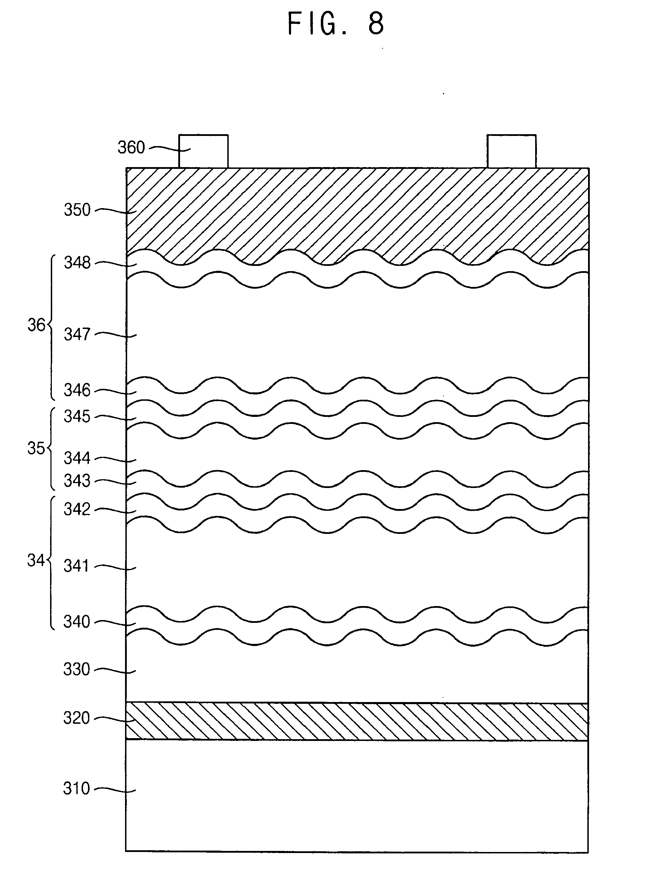

FIG. 8 is a cross-sectional view illustrating a photovoltaic device for a solar cell in accordance with still another embodiment of the present invention.

In FIG 8, the photovoltaic device includes a first cell 34, a second cell 36, and a third cell 35 interposed between the first and second cells 34 and 36. The first cell 34 includes a first light-absorbing layer 341. The second cell 36 includes a second light-absorbing layer 347. The third cell 35 includes a third light-absorbing layer 344.

Referring to FIG. 8, the third cell 35 includes a fifth conductive layer 343, a third light-absorbing layer 344 and a sixth conductive layer 345. The fifth conductive layer 343 has impurities having the same polarity as impurities of a second conductive layer 342 of the first cell 34 and a fourth conductive layer 348 of the second cell 36. The fifth conductive layer 343 includes n-type impurities, and the sixth conductive layer 345 includes p-type impurities. For example, the third light-absorbing layer 344 may include amorphous silicon-germanium, and the bandgap energy of the third light-absorbing layer 344 may be about 1.4 eV to about 1.6 eV.

According to some example embodiments, the deposition temperature of a light-absorbing layer may be increased to decrease hydrogen concentration, thereby preventing deterioration of a photovoltaic device, which may be caused by long exposure to sunlight. Also, a p-semiconductor layer may be formed at a low temperature, so that diffusion of p-type impurities may be decreased. Thus, recombination of electron-hole pairs may be decreased, thereby improving optical characteristics. Furthermore, the light-absorbing layer may be formed at a high temperature, so that the deposition speed of the light-absorbing layer is increased, thereby improving the thickness of a deposition during a deposition process for forming the light-absorbing layer. Thus, a short-circuit current may be increased, so that the efficiency of the photovoltaic element may be improved.

The foregoing is illustrative of the present invention and is not to be construed as limiting thereof. Although a few example embodiments of the present invention have been described, those skilled in the art will readily appreciate that many modifications are possible in the example embodiments without materially departing from the novel teachings and advantages of the present invention. Accordingly, all such modifications are intended to be included within the scope of the present invention as defined in the claims. In the claims, means-plus-function clauses are intended to cover the structures described herein as performing the recited function and not only structural equivalents but also equivalent structures. Therefore, it is to be understood that the foregoing is illustrative of the present invention and is not to be construed as limited to the specific example embodiments disclosed, and that modifications to the disclosed example embodiments, as well as other example embodiments, are intended to be included within the scope of the appended claims. The present invention is defined by the following claims, with equivalents of the claims to be included therein.

## Claims

1. A photovoltaic device comprising:
a first conductive layer on a substrate;
a first light-absorbing layer on the substrate; and
a second conductive layer on the substrate, wherein a hydrogen concentration of the second conductive layer is greater than a hydrogen concentration of the first conductive layer and a hydrogen concentration of the first light-absorbing layer.

2. The photovoltaic device of claim 1, wherein the hydrogen concentration of the first conductive layer is greater than the hydrogen concentration of the first light-absorbing layer and the hydrogen concentration of the second conductive layer, and wherein the hydrogen concentration of the second conductive layer is less than the hydrogen concentration of the first conductive layer and the hydrogen concentration of the first light-absorbing layer, and
wherein the hydrogen concentration of the first light-absorbing layer is less than the hydrogen concentration of the first conductive layer and is greater than the hydrogen concentration of the second conductive layer.

3. The photovoltaic device of claim 2, wherein the first conductive layer comprises an n-semiconductor, and the second conductive layer comprises a p-semiconductor.

4. The photovoltaic device of claim 1, wherein a bandgap energy of the second conductive layer is greater than a bandgap energy of the first conductive layer.

5. The photovoltaic device of claim 4, wherein the bandgap energy of the first conductive layer is less than a bandgap energy of the first light-absorbing layer, and wherein the bandgap energy of the first light-absorbing layer is less than the bandgap energy of the second conductive layer.

6. A photovoltaic device comprising:
a first cell including a first conductive layer, a first light-absorbing layer and a second conductive layer on a substrate; and
a second cell including a third conductive layer, a second light-absorbing layer and a fourth conductive layer on the first cell, wherein a thickness of the second light-absorbing layer is less than a thickness of the first light-absorbing layer, and wherein a hydrogen concentration of the first light-absorbing layer is less than a hydrogen concentration of the second light-absorbing layer.

7. The photovoltaic device of claim 6, wherein the first and second conductive layers comprise an n-semiconductor, and the third and fourth conductive layers comprise a p-semiconductor.

8. The photovoltaic device of claim 7, wherein the hydrogen concentration of the first light-absorbing layer is about 0.1 at% to about 10 at%.

9. The photovoltaic device of claim 8, wherein the hydrogen concentration of the second light-absorbing layer is about 15 at% to about 20 at%.

10. The photovoltaic device of claim 7, wherein a bandgap energy of the first light-absorbing layer is about 1.1 eV to about 1.75 eV.

11. The photovoltaic device of claim 10, wherein a bandgap energy of the second light-absorbing layer is about 1.8 eV to about 2.0 eV.

12. The photovoltaic device of claim 7, wherein a difference between the bandgap energies of the first and second light-absorbing layers is about 0.05 eV to about 0.9 eV.

13. The photovoltaic device of claim 7, wherein the second light-absorbing layer is more adjacent to a light incident surface of the photovoltaic device than is the first light-absorbing layer.

14. The photovoltaic device of claim 7, further comprising a third cell between the first and second cells, the third cell including amorphous or monocrystalline silicon-germanium.

15. The photovoltaic device of claim 7, further comprising a third cell between the first and second cells, the third cell including a third light-absorbing layer, a bandgap energy of the third light-absorbing layer is about 1.4 eV to about 1.6 eV.
